# FASCICULE DE BREVET EUROPEEN

(11) **EP 0 542 594 B1**
(45) Date de publication et mention de la délivrance du brevet: **19.10.1994**
(21) Numéro de dépôt: 92402919.2
(22) Date de dépôt: 26.10.1992
(51) Int. Cl.: H05K 7/14

(54) **Ensemble électronique modulaire**
Modulare elektronische Einheit
Modular electronic unit

(30) Priorité: 14.11.1991 FR 9113997
(43) Date de publication de la demande: 19.05.1993
(73) Titulaire: TELEMECANIQUE, 92504 Rueil Malmaison Cedex (FR)
(72) Inventeur: Chabert, Jean-Marie, F-06560 Valbonne (FR); Goletto, André, F-06600 Antibes (FR)
(74) Mandataire: de Saint-Palais, Arnaud Marie

(56) Documents cités:
- EP-A- 0 162 373
- EP-A- 0 236 711
- DE-A- 3 632 470
- US-A- 4 956 750

## Description

La présente invention concerne un ensemble électronique modulaire notamment, mais non exclusivement, applicable à un appareil de commande d'automatismes tel qu'un automate programmable.

Certains automates programmables à constitution modulaire comprennent, pour assurer une commodité de montage et de démontage individuels :
- des modules électroniques à montage pivotant comportant chacun un boîtier qui loge une carte à circuit imprimé et présente, vers une face arrière verticale, un connecteur,
- un support des modules en forme de plaque présentant une âme verticale munie de connecteurs pour coopérer avec les connecteurs des modules et, pour chaque module, un appui sur lequel celui-ci peut s'appliquer et pivoter, ainsi que des moyens de positionnement et de fixation du module sur le support.

Une telle constitution est connue notamment d'après le brevet EP-A-162 373. Dans une telle solution, des paliers de pivotement prévus à la partie supérieure du boîtier sont posés sur une arête porteuse du support et subissent l'essentiel des efforts de montage communiqués par l'opérateur ; ils risquent donc d'être détériorés ou cassés. En outre, des ressorts sont prévus près des extrémités supérieure et inférieure du support, mais n'ont qu'une fonction de contact électrique, de sorte que la fixation de chaque module nécessite deux vis de fixation situées respectivement aux extrémités supérieure et inférieure du boîtier.

De DE-A-3 632 470 est également connu un ensemble électronique modulaire comportant des modules électroniques à montage pivotant et un support de module. Une butée du boîtier des modules est appliquée frontalement sur le support et met sous contrainte un ressort fixé au sol du support, maintenant ainsi le boîtier contre une paroi verticale dissipatrice de chaleur du support.

L'invention a en particulier pour but de soulager les moyens de pivotement et de simplifier la mise en position et la fixation du module sur le support.

Selon l'invention, les moyens d'application et de pivotement comprennent :
- une face de pose du boîtier, coopérant avec une face horizontale d'appui située à la première extrémité du support, la face de pose pouvant se déplacer horizontalement sur la face d'appui,
- une butée du boîtier applicable frontalement sur une partie avant de l'âme du support et restant appliquée contre l'âme lors du pivotement du module,
- un ressort de serrage disposé entre le boîtier et le support et coopérant avec une portée de manière à être mis progressivement en contrainte lors du pivotement du module.

La première extrémité du boîtier et du support peut être avantageusement leur extrémité inférieure et la face horizontale d'appui peut être formée sur un bandeau horizontal inférieur du support, qui présente un rebord incliné facilitant la présentation oblique des modules.

Le ressort peut être un ressort à lame fixé au support et accrochable par un talon du boîtier ou un ressort de compression logé dans le boîtier du module et sollicitable par une partie en saillie du bandeau d'appui.

Un bandeau horizontal de guidage est avantageusement prévu à la deuxième extrémité du support pour maintenir, lors du pivotement, l'extrémité arrière correspondante du boîtier du module.

La description qui suit, en regard des dessins annexés, permettra de bien comprendre l'invention.
La figure 1 représente en perspective un ensemble électronique conforme à l'invention ;
La figure 2 montre en perspective le support de l'ensemble de la figure 1, sans module ni ensemble de connexion arrière ;
La figure 3 est une élévation latérale de l'ensemble de la figure 1 dont les modules ont été enlevés ;
La figure 4 est une vue en perspective de derrière d'un module ;
Les figures 5 et 6 sont respectivement une vue de côté et une vue de dessous de ce module ;
La figure 7 est une vue en perspective agrandie de dessous d'un détail du module ;
Les figures 8 à 10 montrent les différentes phases du montage d'un module sur le support, dans une variante à âme plane ;
Les figures 11 à 13 représentent le détail A dans ces phases respectives ;
La figure 14 représente le même détail d'une variante de réalisation.

L'ensemble électronique modulaire 10 illustré sur les figures est un appareil de commande d'automatismes tel qu'un automate programmable. Il pourrait bien entendu s'utiliser dans d'autres applications de contrôle ou de commande.

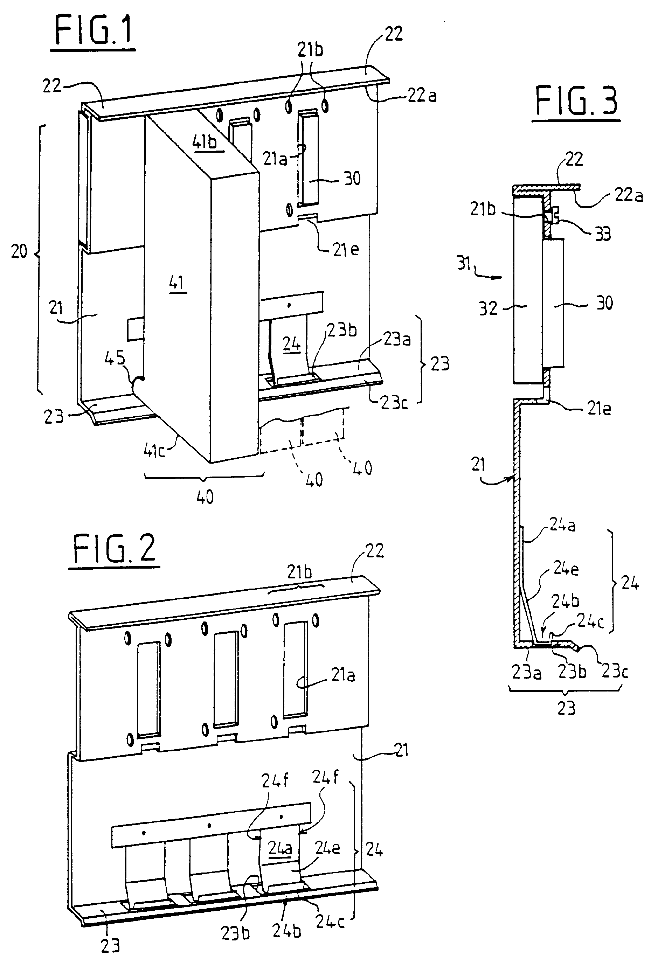

L'ensemble 10 comprend un support 20 et des modules électroniques 40 d'entrée, de sortie, de communication ou autres fixés au support en un certain nombre d'emplacements. Un seul module est montré en traits pleins sur la figure 1 pour la clarté du dessin.

Le support 20 est une plaque métallique, de préférence découpée et pliée, présentant une âme 21, un bandeau supérieur 22 et un bandeau inférieur 23. L'âme verticale 21 est munie de fenêtres 21a pour recevoir des connecteurs 30 qui seront décrits plus loin et elle est munie de trous divers 21b de fixation. Le bandeau de guidage supérieur 22 a une face inférieure horizontale 22a qui contribue au guidage et au maintien des modules. Le bandeau d'appui inférieur 23 a une face supérieure horizontale 23a dans laquelle sont prévues des ouvertures 23b et qui est bordée d'une rampe 23c inclinée vers l'avant, c'est-à-dire vers le côté d'introduction des modules.

Des ressorts de serrage à lame 24 sont prévus en nombre égal à celui des modules à fixer au support. Chaque ressort 24 (voir figure 3) a une première extrémité 24a fixée par tout moyen usuel à l'âme 21 et une deuxième extrémité 24b dotée d'un rebord vertical d'accrochage 24c et d'une portion horizontale 24d. Cette portion 24d se raccorde à une partie intermédiaire oblique 24e du ressort et, pour gagner en hauteur, elle est logée dans l'ouverture 23b pour s'y déplacer lorsque le module pivote en étant accroché au rebord 24c. Les bords avant et arrière de l'ouverture 23b servent de butées à l'extrémité 24b du ressort pour limiter le débattement de celui-ci.

Les connecteurs 30 font partie d'un ensemble de connexion arrière fixe 31 dont le boîtier 32 est logé à l'arrière de l'âme 21, par exemple dans un dégagement procuré par une partie supérieure avancée de l'âme 21. Le boîtier 32 est fixé au support 20 par des vis 33 traversant des orifices 21b.

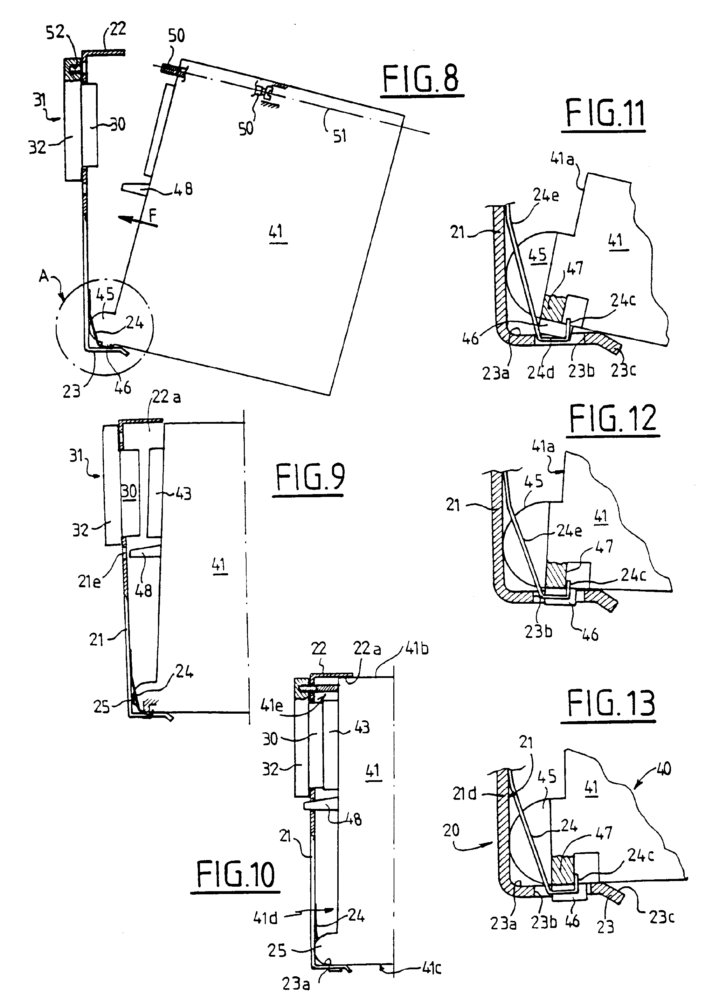

Les connecteurs 30 pourraient également être interconnectés par des câbles souples. Dans une variante plus simple à réaliser (figures 8 à 10), l'âme 21 est plane.

Chaque module 40 possède un boîtier 41 qui loge une carte de traitement électronique 42 à circuit imprimé connectable à l'avant à des organes extérieurs tels que capteurs ou actionneurs par un bornier avant non représenté et, à l'arrière, au connecteur fixe 30 par un fichier bordant la carte ou par un connecteur arrière complémentaire 43.

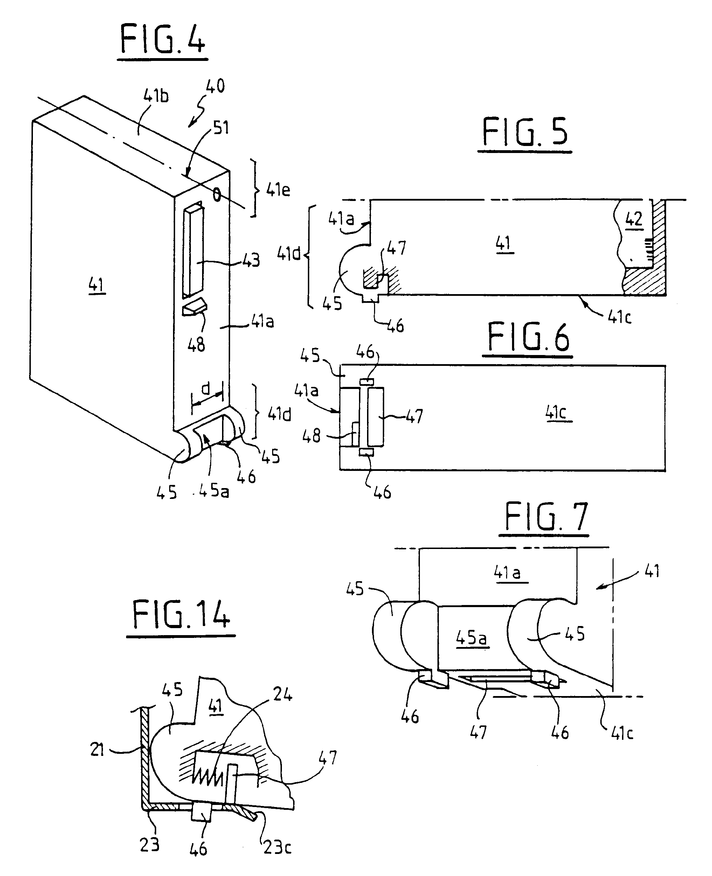

Le boîtier 41 (voir figures 4 à 7) présente une face arrière 41a, une face supérieure 41b et une face inférieure 41c. A l'extrémité inférieure 41d de sa face arrière sensiblement plane 41a se trouvent, d'une part, deux butées 45, ces butées constituant des cames qui interviennent dans le processus de mise en contrainte du ressort et, d'autre part, deux picots 46 de positionnement dans l'ouverture 23b. Les butées 45 ont une surface de came de profil approprié qui permet, pendant le pivotement du module, la prise d'appui sur l'âme 21 pour tirer et mettre en flexion le ressort. Les picots 46 sont destinés à pénétrer dans les ouvertures 23b et à s'appliquer contre les bords latéraux de celles-ci pour positionner le boîtier 41. De plus, la largeur d de l'espace 45a prévu entre les pivots permet de centrer le boîtier du module par rapport au ressort 24 grâce au contact des faces internes des butées 45 contre les bords latéraux 24f de la lame.

De plus, une portée 47, par exemple un talon, est prévue à la partie inférieure 41d du boîtier 41 pour s'accrocher au rebord 24c du ressort afin de le solliciter progressivement lors du pivotement. Un élément complémentaire de positionnement 48 à rampes 49 est prévu à l'arrière du boîtier pour se centrer dans un orifice 21e situé à mi-hauteur de l'âme 21.

Le montage d'un module 40 sur le support 20 va être expliqué en regard des figures 8 à 13 qui montrent un mode de réalisation de support à âme plane.

Le boîtier 41 du module 40 est présenté incliné (figures 8 et 11) de manière que les butées ou cames 45 s'appliquent de part et d'autre de la partie intermédiaire 24e du ressort à lame 24 pour être prépositionnés, puis contre la partie inférieure 21d de l'âme 21. Les picots 46 sont engagés dans l'ouverture 23b du bandeau 23, au contact d'au moins l'un des bords de cette ouverture, ce qui contribue au positionnement du module, et le talon 47 s'introduit derrière le rebord d'accrochage 24c (figures 9 et 12). L'opérateur faisant alors pivoter le boîtier 41 dans le sens antihoraire sur les figures, la surface des cames 45 se déplace légèrement sur l'âme 21, tandis que le talon 47 tire, vers la droite, le rebord 24c du ressort. L'extrémité 24b du ressort et les tenons 46 se déplacent dans l'ouverture 23b qui est dimensionnée en conséquence. L'élément de positionnement 48 pénètre dans l'orifice 21e avant que le connecteur 43, appartenant au boîtier 41, ne s'engage sur le connecteur fixe 30, afin de contribuer au bon accostage de ces connecteurs. La surface supérieure 41b du boîtier 41 glisse contre la surface inférieure 22a du bandeau 22, tandis que la surface inférieure 41c du boîtier continue de reposer sur la surface supérieure 23a du bandeau 23.

La mise en contrainte du ressort 24 et les moyens de positionnement associés assurent une fixation satisfaisante de l'extrémité inférieure arrière 41d du boîtier, tandis que son extrémité supérieure arrière 41e est fixée à l'âme 21 par le serrage d'une vis 50 d'axe 51 dans un écrou 52 rapporté derrière l'âme ou dans le boîtier 32. En pratique, une seule vis de fixation à l'extrémité supérieure du module suffit pour produire une fixation correcte du module sur le support, en conjugaison avec la fixation décrite de son extrémité inférieure. Le démontage du boîtier 41 s'effectuera de manière inverse à ce qui vient d'être décrit pour le montage.

Les dispositions prises pour les extrémités inférieure et supérieure du boîtier pourraient être inversées, la pose et la mise en contrainte du ressort s'effectuant sur un bandeau supérieur du support. Le ressort peut être disposé devant l'âme ou derrière celle-ci.

Dans la variante illustrée par la figure 14, le ressort 24 est un ressort de compression logé dans un évidement du boîtier 41 à l'extrémité inférieure 41d de celui-ci. L'extrémité libre du ressort 24 prend appui, après la pose du boîtier sur la surface 23a du bandeau d'appui 23, contre une portée 47 qui est constituée par une saillie du support, par exemple du bandeau 23.

## Revendications

1. Ensemble électronique modulaire, notamment automate programmable, comprenant :
- des modules électroniques (40) à montage pivotant dont chacun comporte un boîtier qui loge une carte à circuit imprimé et présente, vers une face arrière verticale (41a), un connecteur (43),
- un support (20) des modules en forme de plaque présentant une âme verticale (21) munie de connecteurs (30) pour coopérer avec les connecteurs des modules et, pour chaque module, des moyens d'application et de pivotement, ainsi que des moyens de positionnement et de fixation sur le support,
caractérisé par le fait que les moyens d'application et de pivotement comprennent à une première extrémité du boîtier et du support (20) :
- une face de pose (41c) du boîtier (41), coopérant avec une face horizontale d'appui (23a) située à la première extrémité du support (20), la face de pose pouvant se déplacer horizontalement sur la face d'appui,
- une butée (45) du boîtier applicable frontalement sur une partie avant de l'âme (21) du support et restant appliquée contre l'âme lors du pivotement du module,
- un ressort de serrage (24) disposé entre le boîtier et le support et coopérant avec une portée (47) de manière à être mis progressivement en contrainte lors du pivotement du module.

2. Ensemble selon la revendication 1,
caractérisé par le fait que la première extrémité du boîtier et du support est leur extrémité inférieure et que la face horizontale d'appui (23a) est formée sur un bandeau horizontal inférieur (23) du support.

3. Ensemble selon la revendication 1 ou 2,
caractérisé par le fait que le bandeau présente vers l'avant un rebord incliné (23c).

4. Ensemble selon la revendication 2 ou 3,
caractérisé par le fait qu'au moins un picot de positionnement (46) est prévu à l'extrémité inférieure arrière du boîtier (41) du module pour se loger dans une ouverture (23b) du bandeau d'appui (23).

5. Ensemble selon l'une des revendications 1 à 4,
caractérisé par le fait que le ressort (24) est un ressort à lame fixé à sa première extrémité (24a) au support (20) et muni à sa deuxième extrémité (24b) d'une conformation d'accrochage (24c) coopérant avec la portée en forme de talon (47), ce dernier étant lié au boîtier (41).

6. Ensemble selon la revendication 5,
caractérisé par le fait que les bords latéraux (24f) du ressort à lame (24) constituent des moyens de positionnement du module sur le support.

7. Ensemble selon la revendication 5 ou 6,
caractérisé par le fait que la deuxième extrémité (24b) du ressort à lame (24) est logée dans une ouverture (23b) du bandeau d'appui (23).

8. Ensemble selon l'une des revendications 1 à 4,
caractérisé par le fait que le ressort (24) est un ressort de compression logé dans le boîtier (41) et sollicitable à une extrémité (24b) par la portée en forme de talon (47), ce dernier étant constitué par une partie en saillie du bandeau d'appui (23).

9. Ensemble selon l'une des revendications 1 à 8,
caractérisé par le fait que le support (20) comprend à son extrémité supérieure un bandeau de guidage (22) pour maintenir lors du pivotement une deuxième extrémité (41e) arrière du boîtier (41) du module.

10. Ensemble selon l'une des revendications 1 à 9,
caractérisé par le fait que les moyens de fixation comprennent une vis unique (50) située à une deuxième extrémité (41e) du boîtier (41).

## Patentansprüche

1. Modulare elektronische Einheit, insbesondere ein programmierbarer Automat mit :
- schwenkbar montierbaren elektronischen Modulen (40), von denen jeder ein, eine gedruckte Leiterkarte aufnehmendes, Gehäuse und, auf der hinteren, senkrechten Fläche (41a), einen Verbinder (43) aufweist,
- einem plattenförmigen Modulträger (20) mit einer senkrechten Wand (21), die mit Verbindern (30) versehen ist, welche mit den Modulverbindern zusammenwirken und, je Modul, Anlage- und Schwenkmitteln, sowie Positionierund Befestigungsmitteln am Träger,
dadurch gekennzeichnet, dass die Anlage- und Schwenkmittel an einem ersten Ende des Gehäuses und des Trägers (20) aufweisen :
- eine Montagefläche (41c) des Gehäuses (41), die mit einer waagerechten, am ersten Ende des Trägers (20) vorgesehenen Auflagefläche (23a) zusammenwirkt, wobei die Montagefläche auf der Auflagefläche horizontal verschiebbar ist,
- einen Gehäuseanschlag (45), der von vorne her an einen vorderen Teil der Trägerwand (21) angelegt werden kann und bei einer Schwenkung des Moduls gegen besagte Wand angelegt bleibt,
- eine zwischen dem Gehäuse und dem Träger angeordnete Klemmfeder (24), die mit einer Tragfläche (47) so zusammenarbeitet, dass sie allmählich bei Schwenkung des Moduls beaufschlagt wird.

2. Einheit nach Anspruch 1,
dadurch gekennzeichnet, dass das erste Ende des Gehäuses und des Trägers deren unteres Ende ist und die waagerechte Auflagefläche (23a) auf einer unteren waagerechten Leiste (23) des Trägers gebildet ist.

3. Einheit nach Anspruch 1 oder 2,
dadurch gekennzeichnet, dass die Leiste vorn einen schrägen Rand (23c) aufweist.

4. Einheit nach Anspruch 2 oder 3,
dadurch gekennzeichnet, dass mindestens ein Positioniervorsprung (46) am unteren hinteren Ende des Modulgehäuses (41) vorgesehen ist, der in eine Öffnung (23a) der Auflageleiste (23) eindringt.

5. Einheit nach einem der Ansprüche 1 bis 4,
dadurch gekennzeichnet, dass die Feder (24) eine Blattfeder ist, deren erstes Ende (24a) am Träger (20) befestigt ist, und deren zweites Ende (24b) mit einer Einfangausbildung (24c) versehen ist, die mit der Tragfläche in Form eines mit dem Gehäuse verbundenen Absatzes (47) zusammenarbeitet.

6. Einheit nach Anspruch 5,
dadurch gekennzeichnet, dass die Seitenränder (24f) der Blattfeder (24) Positioniermittel für den Modul auf dem Träger bilden.

7. Einheit nach Anspruch 5 oder 6,
dadurch gekennzeichnet, dass das zweite Ende (24b) der Blattfeder (24) in einer Öffnung (23b) der Auflageleiste (23) angeordnet ist.

8. Einheit nach einem der Ansprüche 1 bis 4,
dadurch gekennzeichnet, dass die Feder (24) eine im Gehäuse (41) angeordnete Druckfeder ist, die an einem Ende (24b) von der Tragfläche in Form eines Absatzes (47) beaufschlagt werden kann, wobei diese letztere von einem vorspringenden Teil der Auflageleiste (23) gebildet ist.

9. Einheit nach einem der Ansprüche 1 bis 8,
dadurch gekennzeichnet, dass der Träger (20) an seinem oberen Ende eine Führungsleiste (22) aufweist, um bei einer Schwenkung das zweite hintere Ende (41e) des Modulgehäuses (41) zu halten.

10. Einheit nach einem der Ansprüche 1 bis 9,
dadurch gekennzeichnet, dass die Befestigungsmittel eine einzige, an einem zweiten Ende (41e) des Gehäuses (41) angeordnete Schraube (50) aufweisen.

## Claims

1. A modular electronic unit, notably a programmable controller, comprising:
- pivotably mounted electronic modules (40), each comprising a housing containing a printed circuit board and having, towards a rear vertical side (41a), a connector (43),
- a module supporting device (20) in the form of a plate having a vertical web plate (21) fitted with connectors (30) for cooperating with the connectors of said modules and, for each module, means for applying and pivoting, and means for positioning and securing said module to said support,
characterized in that said applying and pivoting means comprises at a first end of said housing and of said support (20):
- a fitting side (41c) of said housing (41), cooperating with a horizontal bearing side (23a) situated at said first end of said support (20), said fitting side being horizontally moveable on said bearing side;
- a stop (45) of said housing applying frontally against a front part of said web plate (21) of said support and remaining applied against said web plate during pivoting of said module,
- a tightening spring (24) placed between said housing and said support and cooperating with a bearing surface (47) in such a way as to have stress gradually brought to bear upon it during pivoting of said module.

2. The unit as claimed in claim 1, characterized in that said first end of said housing and of said support is their lower end and said horizontal bearing side (23a) is formed by a lower horizontal fascia (23) of said support.

3. The unit as claimed in claim 1 or 2, characterized in that said fascia has a slanted edge (23c) at the front.

4. The unit as claimed in claim 2 or 3, characterized in that at least one positioning pin (46) is provided at the lower rear end of said housing (41) of said module for lodging in an opening (23b) of said bearing fascia (23).

5. The unit as claimed in one of claims 1 to 4, characterized in that said spring (24) is a leaf spring secured at its first end (24a) to said support (20) and fitted at its second end (24b) with a catching conformation (24c) cooperating with the bearing surface in the form of a heel (47), the latter being connected to said housing (41).

6. The unit as claimed in claim 5, characterized in that the lateral edges (24f) of said leaf spring (24) constitute means for positioning said module on said support.

7. The unit as claimed in claim 5 or 6, characterized in that said second end (24b) of said leaf spring (24) is lodged in an opening (23b) of said bearing fascia (23).

8. The unit as claimed in one of claims 1 to 4, characterized in that said spring (24) is a compression spring lodged in said housing (41) which can be stressed at one end (24b) by said bearing surface in the form of a heel (47), the latter being comprised of a protruding part of said bearing fascia (23).

9. The unit as claimed in one of claims 1 to 8, characterized in that said support (20) comprises at its upper end a guide fascia (22) for maintaining a second rear end (41e) of said module housing (41) during pivoting.

10. The unit as claimed in one of claims 1 to 9, characterized in that said securing means comprises a single bolt (50) situated at a second end (41e) of said housing (41).
